# EUROPEAN PATENT APPLICATION

(11) **EP 0 713 356 A1**
(43) Date of publication of application: **22.05.1996**
(21) Application number: 95306753.5
(22) Date of filing: 25.09.1995
(51) Int. Cl.: H05K 1/02, H05K 3/30, B60R 16/02

(54) **Electrical circuit boards**

(30) Priority: 17.11.1994 US 341233
(71) Applicant: Ford Motor Company, Dearborn, MI 48126 (US)
(72) Inventor: Jurasek, Gordan, Canton, Michigan 48188 (US); Zaderej, Victor Vasyl, Branford, Connecticut 06405 (US); Gerrelts, Douglas Paul, Romulus, Michigan 48174 (US)
(74) Representative: Messulam, Alec Moses

(57) **Abstract**

A circuit board for an instrument cluster comprises injection-moulded plastic springs (102, 104) connecting islands (96) of the circuit board to a main portion (101) of the circuit board (34). Each island further has integrally-moulded clips (72) residing in the plane of the island (96). The clips are adapted for insertion and retention of terminal posts of electrical gauge movements. When the electrical gauge movements are attached to the circuit board (34) via the clips, the springs (102, 104) provide compliance so that the gauge movements can then be attached to one or more face plates of the instrument cluster. The compliance provided by the springs allows tolerance stack-ups among the various components of the instrument cluster assembly to be overcome.

## Description

### Field of the invention

The present invention relates to circuit boards for interconnecting electrical and electronic components and is particularly applicable to circuit boards used in the instrument clusters of motor vehicles.

### Background of the invention

In the assembly of automotive instrument clusters with analog gauges, one or more gauge movements are attached to the backs of one or more face plates of the instrument cluster. The front of each face plate contains an appliqué with graduations (such as "miles per hour" graduations for a speedometer). Pointers attached to staffs of the gauge movements indicate the gauge readings with reference to the graduations on the appliqués.

A typical automotive instrument cluster contains four or more gauges. This implies that four or more gauge movements are attached to the backs of the face plates. Each gauge movement is typically attached by means of two screws which are driven through mounting holes on the gauge movements and into mounting bosses on the back of a face plate.

In the assembly of a typical instrument cluster, the gauge movements are connected to a circuit board, which provides the electrical signals to drive the gauge movements. In one prior art assembly method, this connection is made through holes in the circuit board, one hole for each terminal of each gauge movement. Once the terminals are inserted into the holes, the terminals are soldered to the circuit board. After the terminals have been soldered to the circuit board, each gauge movement is screwed to the back of a face plate of the cluster, as discussed above.

However, this latter step of attaching the gauge movements to the backs of the face plates can pose some difficulty. Once the terminals of the gauge movements are soldered to the circuit board, the gauge movements are rigidly fixed to the circuit board. However, tolerance stack-ups in the various components of the instrument cluster make it likely that not all of the gauge movements will then be exactly positioned for mounting to the backs of the face plates.

One solution to this problem is disclosed in pending U.S. patent application 08/136,843, by Davis. This application discloses the provision of "islands" on the circuit board, which contain the holes into which the terminals of the gauge movements are inserted. These islands are each connected to the remainder of the circuit board by springs formed in the circuit board material. The gauge movements thus attached to those islands are therefore somewhat compliantly connected to the circuit board. This compliance allows the above-referenced tolerance stack-up to be overcome and all of the gauge movements to be attached to the face plates of the instrument cluster.

However, the invention disclosed by Davis, although effective, still has two shortcomings. First, the circuit board in the embodiment disclosed therein is made of fibreglass material and the springs formed in the circuit board are formed by punching. The resulting springs are therefore of rather large dimensions. Smaller springs would allow a more compact instrument cluster to be made. Second, Davis discloses soldering of the gauge movement terminals to the circuit board. If this step can be eliminated in attaching the gauge movement terminals to the circuit board (as well as other prior-art methods of attaching gauge movements to a circuit board such as clips mounted to the circuit board), the instrument cluster can likely be assembled more simply and inexpensively.

### Summary of the invention

According to the present invention, there is provided a circuit board comprising a first portion and an island having electrical connection means thereon for connection to an electrical component and resiliently connected to said first portion by spring means, the first portion, the spring means and the island being formed integrally of a plastics material.

Preferably, the first portion, the island and the spring means are all coplanar.

Conveniently, the electrical connection means comprise clips that lie in the same plane as the island each clip further comprising two electrically conductive walls in opposition to one another, the walls defining an aperture extending through the planar portion. The walls of the clip are preferably of a thickness and have a spacing to be elastically deformed by and to grip a terminal post of an electrical component when the post is inserted into the aperture.

The present invention allows for more compact construction of an instrument cluster. Further, the clips in the preferred embodiment of the invention allow connection of electrical components to a circuit board without solder and without separate attaching means mounted to the circuit board.

### Brief description of the drawings

The invention will now be described further, by way of example, with reference to the accompanying drawings, in which :-
Figure 1 is an exploded view of an instrument cluster.
Figure 2 is a rear perspective view of face plate sub-assembly of the instrument cluster in Figure 1,
Figure 3 is an exploded view of the face plate sub-assemblies and the circuit board of the instrument cluster,
Figure 4 is a front view of the circuit board of instrument cluster,
Figure 5 is a view to an enlarged scale of an island and springs on the circuit board of Figure 4,
Figure 6 is a sectional view a clip 72 on the circuit board, taken along line 6-6 of Figure 5, and
Figure 7 is a sectional view similar to that of Figure 6 further showing the insertion of a terminal of a gauge movement into the clip.

### Detailed description of the preferred embodiment

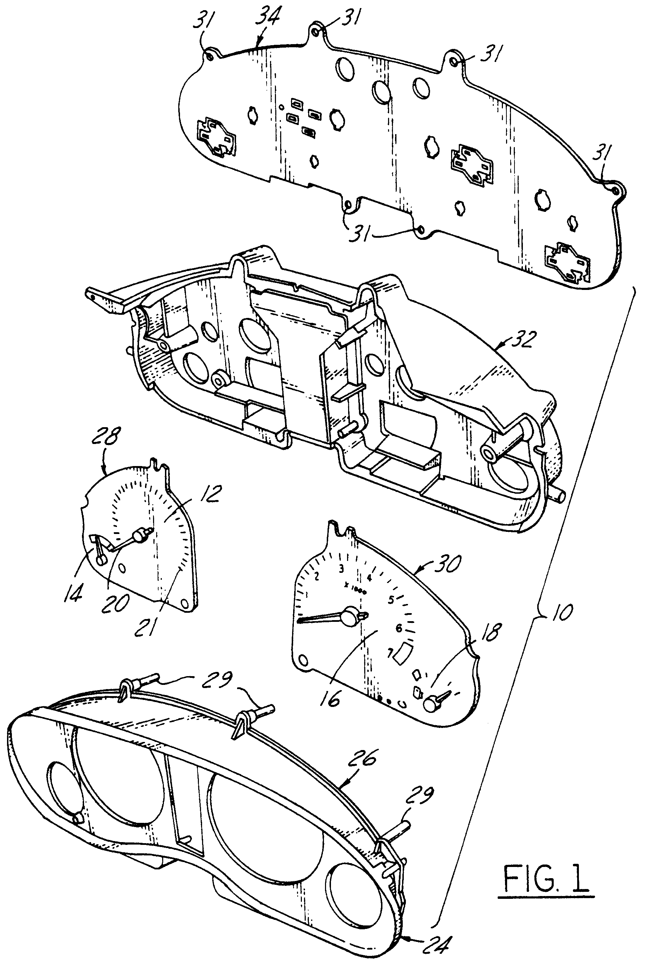

Figure 1 shows an instrument cluster 10 according to one embodiment of the invention. The instrument cluster 10 comprises four gauges 12, 14, 16 and 18. Gauges 12, 14, 16 and 18 each further comprise a pointer (for example, pointer 20 on gauge 12). The pointers are mounted on gauge movements (not shown in Figure 1). The gauge movements drive the pointers to the proper rotational position to display the gauge readings on graduations (for example, graduations 21) on the face of the instrument cluster 10.

The instrument cluster 10 comprises a clear plastics lens 24. The lens 24 attaches to a plastics bezel 26, which has four openings through which the gauges 12, 14, 16 and 18 can be viewed. Behind the bezel 26 are two face plate sub-assemblies 28 and 30. The gauges 12 and 14 are parts of the face plate sub-assembly 28, and the gauges 16 and 18 are parts of the face plate sub-assembly 30. The bezel 26 attaches to a plastics housing 32 and to a circuit board 34 via screws driven through holes 31 in the circuit board 34 into bosses 29 in the bezel 26.

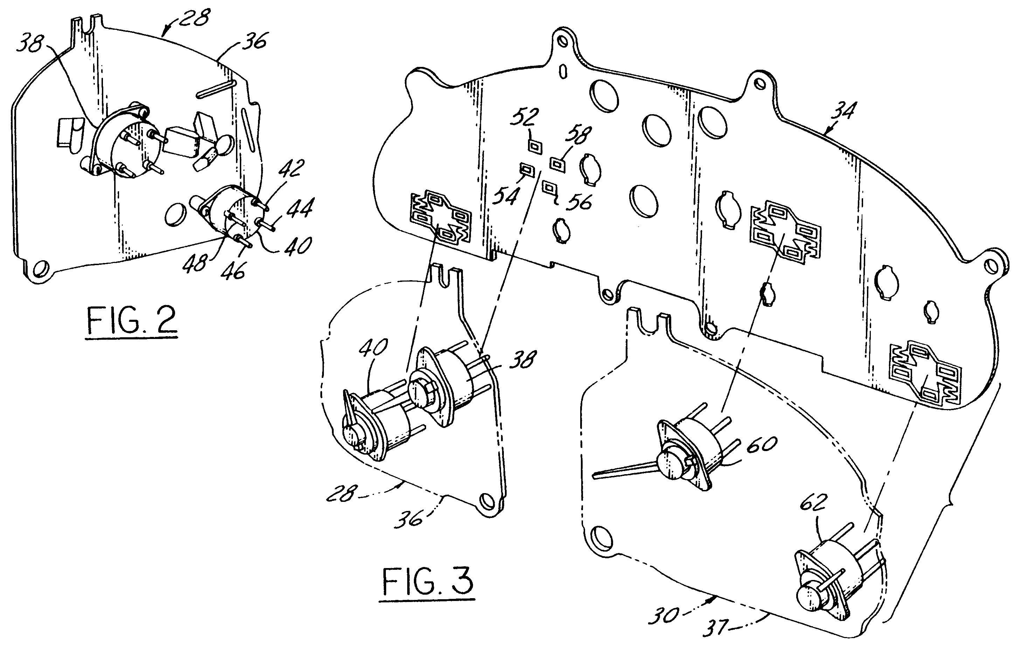

Figure 2 shows a rear perspective view of the face plate sub-assembly 28. The face plate sub-assembly 28 comprises a plastics face plate 36. Gauge movements 38 and 40 are screwed to the face plate 36 for the gauges 12 and 14, respectively. The gauge movements 38 and 40 each have four electrical terminal posts (or "leads"). For example, the terminal posts on gauge movement 40 are designated 42, 44, 46 and 48. The terminal posts are cylindrical, as is usual in the art.

It is important to note that once the gauge movements 38 and 40 are attached to the face plate 36, the positions of the terminal posts of the gauge movements 38 and 40 are fixed. That is, the attachment of the gauge movements 38 and 40 to the face plate 36 is essentially rigid. On the other hand, the positions of the gauge movements 38 and 40 from one face plate sub-assembly to another are subject to slight variation. This variation is due to dimensional variations in the face plate 36, which is an injection-moulded plastics part. Because the positions of the gauge movements 38 and 40 vary from one face plate sub-assembly to another, the position of the terminal posts of the gauge movements 38 and 40 also vary from one face plate sub-assembly to another.

Figure 3 shows only the face plate sub-assemblies 28 and 30 and the circuit board 34. In this figure, face plates 36 and 37 are shown in shadow, so that the terminal posts of the gauge movements 38, 40, 60 and 62 may be seen. The circuit board 34 comprises clips (such as clips 52, 54, 56 and 58) for gripping the terminal posts of the gauge movements 38, 40, 60 and 62 and for making the electrical connections of the terminal posts to the circuit board 34. However, because the terminals are rigidly attached within the face plate sub-assemblies 28 and 30, and because there is the aforementioned variation of the locations of the terminal posts, some ability for the clips to move within the plane of the circuit board 38 is needed to facilitate insertion of the terminal posts into the clips.

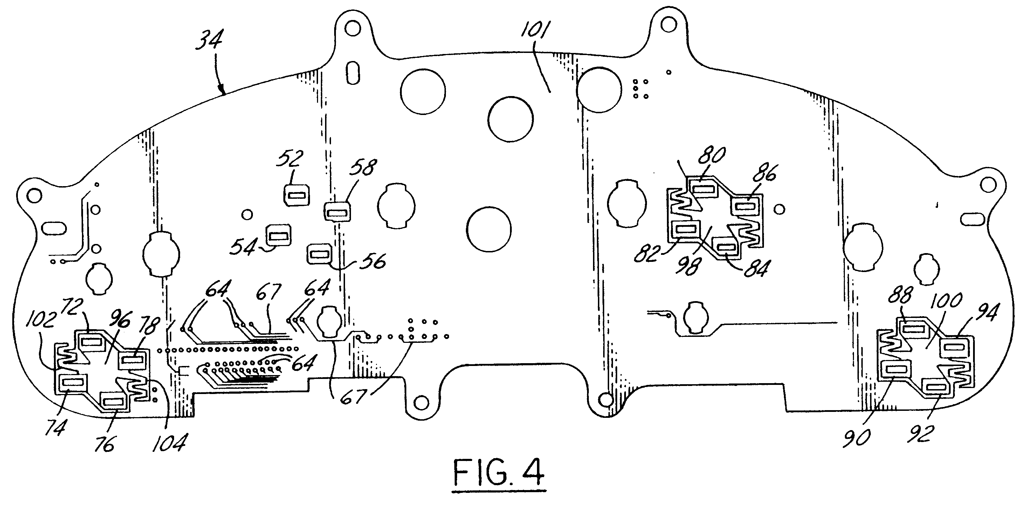

Figure 4 shows the circuit board 34 in greater detail. The circuit board 34 is preferably a two-layer circuit board. In the described embodiment of instrument cluster 10, the circuit board 34 has attached to it electronic components (integrated circuits, resistors, capacitors, and the like) to perform various functions of the instrument cluster 10. Because of those electronics, the circuit board 34 contains numerous through holes (such as holes 64) for attachment of the electronic components. Circuit board 34 further comprises embedded conductive tracks (such as circuit tracks 67), for carrying electrical signals between the various components connected to the circuit board 34.

The circuit board 34 further comprises the aforementioned clips 52, 54, 56 and 58, as well as clips 72, 74, 76, 78, 80, 82, 84, 86, 88, 90, 92 and 94. These 16 clips are for the sixteen terminal posts of the four gauge movements 38, 40, 60 and 62. Clips 72, 74, 76, 78, 80, 82, 84, 86, 88, 90, 92 and 94 are located on islands 96, 98 and 100. The islands 96, 98 and 100 are isolated from the main portion 101 of the circuit board 34 by springs (for example, springs 102 and 104 which isolate the island 96). The islands and the clips on the islands (for example, clips 72, 74, 76 and 78 on island 96) are thus free to move relative to the rest of the circuit board 34 along mutually orthogonal axes lying within the plane of the circuit board 34. There is also some freedom along a third axis normal to the plane of the circuit board 34, but that is not particularly important in mitigating the problem of misalignment between gauge movement terminal posts and their clips.

The two-axis movement of islands 96, 98 and 100 allows the clips (for example, clips 72, 74, 76 and 78) to be moveable for alignment with the terminal posts of the gauge movements (for example, terminal posts 42, 44, 46 and 48) when mating of the terminal posts and the circuit board 34 is performed. This overcomes the alignment problem caused by variation in the locations of the terminal posts of the gauge movements 38, 40, 60 and 62 after the gauge movements have been attached in the face plate sub-assemblies 28 and 30.

The circuit board 34 is preferably injection moulded from a plastics material, preferably polyetherimide. This material is available from the General Electric Corporation under the trade name "Ultem". The injection moulding produces a substrate which has the physical features of the circuit board 34, including holes (such as holes 64), clips (such as clips 72, 74, 76 and 78), islands 96, 98 and 100 and springs (such as springs 102 and 104). Once the substrate is so formed, copper is selectively applied to the top and bottom surfaces of the substrate to form circuit tracks (such as circuit tracks 67). The holes of circuit board 34 (such as holes 64) and the clips (such as clips 72, 74 and 76 and 78) are also copper plated. The copper application processes are conventional in the art and need not be described in detail.

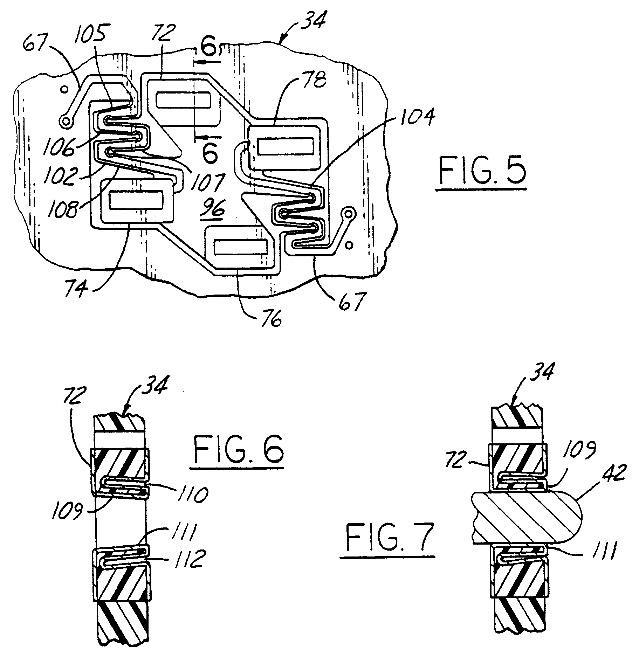

It will be appreciated from the description of the circuit board 34 that the main portion 101, springs (such as springs 102 and 104) and islands 96, 98 and 100 are integrally formed. That is to say, they are formed at the same time, with no subsequent attachment process or attachment means employed to join them together. Figure 5 also illustrates that the main portion 101, the springs (such as springs 102 and 104) and the islands 96, 98 and 100 reside in a common plane.

Referring now to Figure 5, the spring 102 will be described in more detail, the spring 102 being typical of the other springs disclosed herein. The spring 102 comprises beams 105, 106, 107 and 108. The beams each have a length and a width. The width of beams 105, 106, 107 and 108 is preferably about 2 mm or less. Injection moulding, the preferred process for fabricating the circuit board 34, helps make the relatively small 2 mm width practical. Such a small width helps keep the circuit board 34 and therefore also the instrument cluster 10 compact.

It will also be noted in Figure 5 that circuit tracks 67 extend from the clips 74 and 78 along the tops of the springs 102 and 104. In the preferred embodiment of the present invention, those conductive tracks 67 are the means by which electrical signals are routed from the clips 74 and 78 to the remainder of the circuit board 34. Similar circuit tracks from the clips 72 and 76 run along the bottoms of the springs 102 and 104.

The clip 72 will now be described by reference to Figure 6, this clip 72 being typical of all sixteen clips 52, 54, 56, 58, 72, 74, 76, 78, 80, 82, 84, 86, 88, 90, 92 and 94 disclosed herein. The clip 72 comprises two walls 109 and 111, adjacent to which are voids 110 and 112, respectively. Walls 109 and 111 are copper plated and in turn electrically connected via plating to circuit tracks of the circuit board 34 (as discussed in the previous paragraph). The clip 72 is located in the plane of the island 96.

Referring now to Figure 7, when a terminal post (for example, terminal post 42) of a gauge movement is inserted into the clip 72, interference between terminal post 42 and walls 109 and 111 causes the walls 109 and 111 to be pushed toward voids 110 and 112 (Fig. 6) by the terminal post 42. However, the walls 109 and 111 are only elastically, not permanently, deformed. The walls 109 and 111 thus exert pressure on the terminal post 42, holding terminal post 42 in place. In this way, gauge movements 38, 40, 60 and 62 can be attached mechanically and electrically to the circuit board 34 without solder and without the separate clips that are typically used to attach gauge terminal posts to circuit boards. One of ordinary skill in the art will certainly recognise that the clips disclosed herein (such as clip 72) can be used for attachment of various other electrical and electronic components having terminal posts, in addition to electrical gauge movements.

## Claims

1. A circuit board (34) comprising a first portion (101) and an island (96) having electrical connection means 72,74,76,78) thereon for connection to an electrical component and resiliently connected to said first portion (101) by spring means (102,104), the first portion (101), the spring means (102,104) and the island (96) being formed integrally of a plastics material.

2. A circuit board as claimed in Claim 1, wherein said spring means (102,104), said island (96) and the first portion (101) all reside in a common plane.

3. A circuit board as claimed in Claim 1 or 2, wherein the spring means comprise at least one spring that is plated with an electrical conductor.

4. A circuit board as claimed in any preceding claim, wherein the spring means comprise springs (102) formed of mutually inclined beams (105-108), having a width no greater than approximately 2 mm.

5. A circuit board as claimed in any preceding claim, wherein said first portion (101), said island (96) and said spring means (102,104) are fabricated by injection moulding.

6. A circuit board as claimed in any preceding claim, wherein:
said island is substantially planar; and
the electrical connection means on the island comprise a plurality of clips (72-76) which reside in the plane of said island (96), wherein each clip further comprises two electrically conductive walls (109,111) in opposition to one another, said walls defining an aperture extending through said island, said walls (109,111) being of a thickness and having a spacing to be elastically deformed by and to grip a terminal post (42) of an electrical component when said terminal post is inserted into said aperture.

7. A circuit board as claimed in Claim 6, wherein said 72-76) clips are integrally formed of a plastics material with said island and wherein said clips are coated with an electrically conductive material.

8. An instrument cluster for a motor vehicle, comprising a circuit board as claimed in any preceding claim and further including:
a face plate (28,30); and
at least one electrical gauge movement (38) mounted on the face plate (28,30) and having a plurality of electrical terminal posts connected to the electrical connection means on an island (96) of the circuit board (34).

9. An instrument panel as claimed in claim 8, having a plurality of gauge movements (38) mounted on a plurality of face plate sub-assemblies (28,30), the circuit board (34) having a plurality of islands (96,98,100) each with electrical connection means for the terminal posts of a respective one of the gauges.
